# EUROPEAN PATENT SPECIFICATION

(11) **EP 3 137 646 B1**
(45) Date of publication and mention of the grant of the patent: **19.02.2020**
(21) Application number: 15785781.4
(22) Date of filing: 19.03.2015
(51) Int. Cl.: C23C 14/34, C23C 14/35, H01J 37/34, H01J 37/32

(54) **SPUTTERING APPARATUS**
SPUTTERVORRICHTUNG
APPAREIL DE PULVÉRISATION

(30) Priority: 28.04.2014 US 201414263250
(43) Date of publication of application: 08.03.2017
(73) Proprietor: Sputtering Components, Inc., Owatonna, Minnesota 55021 (US)
(72) Inventor: CROWLEY, Daniel Theodore, Owatonna, Minnesota 55060 (US); MORSE, Patrick Lawrence, Tucson, Arizona 85745 (US); GERMAN, John Robert, Owatonna, Minnesota 55060 (US); MEREDITH, William A., Faribault, Minnesota 55021 (US)
(74) Representative: Gill Jennings & Every LLP
(86) International application number: PCT/US2015/021506
(87) International publication number: WO 2015/167687

(56) References cited:
- WO-A1-2009/138348
- JP-A- H1 161 403
- US-A1- 2004 050 690
- US-A1- 2006 000 705
- US-A1- 2010 243 428
- US-A1- 2011 062 022
- US-A1- 2014 097 080

## Description

Magnetron sputtering of rotating targets is well known and is used extensively for producing a wide variety of thin films on a wide variety of substrates. In the most basic form of rotating-target magnetron sputtering, the material to be sputtered is either formed in the shape of a tube or is adhered to the outer surface of a support tube made of a rigid material. A magnetron assembly is disposed within the tube and supplies magnetic flux, which permeates the target such that there is adequate magnetic flux at the outer surface of the target. The magnetic field produced by the magnetron assembly is designed in a way such that it retains electrons emitted from the target so as to increase the probability that they will have ionizing collisions with the working gas, hence enhancing the efficiency of the sputtering process.

It is becoming increasingly important to compensate for target erosion effects because it is desirable to increase target thickness and operate sputter processes under more sensitive process conditions. The desire for thicker targets is largely driven by fabrication costs of ceramic targets, but is also desirable in order to have a greater inventory of usable material inside the sputter coater in order to run longer coating campaigns. The need to run processes in more sensitive process conditions is driven by the desire to get higher deposition rates, in reactive mode sputtering, and/or to finely control film chemistry.

Fabrication cost for targets of some materials, in particular ceramic transparent conductive oxide (TCO) materials, are relatively high in comparison to the cost of the raw materials. To improve the economy of these targets, it is desirable to increase the thickness of the target material. In this way, the target will have significantly more usable material while adding only minimally to the overall cost of the target, as the fabrication cost does not change significantly. The only significant cost increase is due to the additional raw material used. In addition, thicker targets have the added benefit of allowing longer production campaigns between target changes.

Increasing the target thickness too much, however, can result in inadequate magnetic flux at the target surface when using standard magnetron assemblies. Magnetron designs with higher magnetic flux have recently been introduced to provide the higher magnetic flux required for the thicker targets.

In the case of reactive magnetron sputtering, metallic targets are sputtered in an atmosphere that contains reactive gas such as oxygen or nitrogen. The sputtered material reacts with the reactive gas in order to form a film comprised of compounds of the target material and the reactive gas. The reactive gas also reacts with the target surface, thereby forming reacted compounds on the target surface. The surface compounds greatly reduce the ablation rate. In order to improve the sputtering efficiency, the amount of reactive gas may be carefully controlled so as to minimize the target surface reactions while still achieving the desired film chemistry. In some cases, the processes need to be controlled such that the chemistry of the film is sub-stoichiometric.

This fine control over the process gas makes the process sensitive to small perturbations. The industry has seen considerable technological advances in power delivery and process gas control that have minimized many of the process perturbations. Nevertheless, little has been done to minimize variations in the magnetic confinement of the plasma. As the target erodes, the working surface gets closer to the magnetic assembly and the magnetic field becomes stronger. This changes the confinement of the plasma, altering the dynamics of the sputtering process. This presents a challenge in maintaining long-term stability of the process.

The typical magnetron assembly for rotating cathodes comprises three substantially parallel rows of magnets attached to a yoke of magnetically conductive material, such as steel, that helps complete the magnetic circuit. The direction of magnetization of the magnets is radial with respect to the major axis of the sputtering target. The center row of magnets has the opposite polarity of the two outer rows of magnets.

Magnetic flux of the inner and outer rows of magnets is linked through the magnetically conductive yoke, on one side of the magnets. On the other side of the magnets, opposite the yoke, the magnetic flux is not contained in a magnetically conductive material. Hence, the magnetic flux permeates substantially unimpeded through the target, which is substantially non-magnetic. Thus, two arc-shaped magnetic fields are provided at and proximate to the working surface of the target. These fields retain the electrons and cause them to drift in a direction perpendicular to the magnetic field lines, which is parallel to the rows of magnets. This is known as the ExB drift. In an ordinary arrangement, this drift path is also parallel to the major axis of the target.

Additionally, the outer rows of magnets are slightly longer that the inner row of magnets, and additional magnets, of the same polarity as the outer rows, are placed at the ends of the assembly between the two outer rows creating the so-called "turnaround" areas of the drift path. This has the effect of connecting the two drift paths, hence forming one continuous ovular "racetrack" drift path. This optimizes the retention of the electrons and therefore optimizes the efficiency of the sputtering process.

As the target erodes, the working surface comes closer to the magnet assembly, and the intensity of the magnetic field, at the working surface, increases in a non-linear fashion. For finely controlled processes it very desirable to modify the magnetic field, as the target erodes, so as to minimize variability of the process, thereby making the process easier to control over the course of the target life.

The need for changing the magnetic field as the target erodes is well known, and has been accomplished in the case of planar sputtering cathodes. The need for an adjustable magnetron for rotating cathodes has gone unsatisfied, however, because the geometry and mechanical structure of the cathodes make the task especially challenging.

International Publication WO 2013/120920 (the '920 publication) discloses an end-block for rotatably carrying a sputter target tube and restraining an adjustable magnet bar inside the target tube. Connectors are employed inside the end-block for power and communication feeds. Use of these connectors would require significant redesign of a typical end-block, making retro-fitting of older cathodes infeasible with such connectors.
US-A- 2014/097080 discloses a magnetron assembly for a rotary target cathode, comprising a support structure, a magnet bar and a number of drive modules for moving the magnet bar, and a controller coupled to the support and communicating with the drive modules.

### SUMMARY

The present invention provides a magnetron assembly for a rotary target cathode, as defined in claim 1, and a rotary target cathode assembly as defined in claim 10. In one embodiment, the magnetron assembly comprises an elongated support structure, a magnet bar structure movably positioned below the support structure, and a plurality of drive modules coupled to the support structure. The drive modules each include a motorized actuation mechanism operatively coupled to the magnet bar structure. A controller and battery module is coupled to the support structure and is in operative communication with the drive modules. The controller and battery module includes an electronic controller and at least one rechargeable battery. The battery is configured to energize each motorized actuation mechanism and the electronic controller. One or more power generation modules is coupled to the support structure and in electrical communication with the battery, such that electrical energy output from the power generation modules recharges the battery.

### BRIEF DESCRIPTION OF THE DRAWINGS

Figure 1 is a perspective view of a magnetron assembly for a rotatable target cathode according to one embodiment;
Figure 2 is an end view of the magnetron assembly of Figure 1;
Figure 3 is a side view of the magnetron assembly of Figure 1 ;
Figure 4 is a cross-sectional side view of the magnetron assembly taken along line 4-4 of Figure 2;
Figure 5 is an enlarged sectional view of the magnetron assembly taken along line 5-5 of Figure 4;
Figure 6 is a cross-sectional end view of the magnetron assembly taken along line 6-6 of Figure 3;
Figure 7 is a cross-sectional side view of a magnetron assembly in a rotatable target cathode according to another embodiment;
Figure 8 is an enlarged sectional view of the magnetron assembly taken along line 8-8 of Figure 7;
Figure 9 is a partial cross-sectional side view of a sputtering apparatus according to one embodiment;
Figure 10 is a schematic illustration of a sputtering apparatus according to another embodiment;
Figure 11 is a perspective view of a magnetron assembly for a rotary target cathode according to another embodiment;
Figure 12 is a top view of the magnetron assembly of Figure 11, with some of the components removed to show internal structures;
Figure 13 is an end view of a rotary target cathode according one embodiment that contains the magnetron assembly of Figure 11;
Figure 14 is a cross-sectional side view of the rotary target cathode taken along line 14-14 in Figure 13;
Figure 15 is an enlarged sectional view of an end portion of the rotary target cathode taken along line 15-15 in Figure 14;
Figure 16 is an end view of a rotary target cathode according another embodiment that contains the magnetron assembly of Figure 11;
Figure 17 is a cross-sectional side view of the rotary target cathode taken along line 17-17 in Figure 16; and
Figure 18 is an enlarged sectional view of an end portion of the rotary target cathode taken along line 18-18 in Figure 17.

### DETAILED DESCRIPTION

An apparatus and technique for rotating-cathode magnetron sputtering is provided that deals with the variation in magnetic intensity at the sputtering surface as a target erodes, which results in changing process conditions. By magnetically compensating for target erosion effects, the present approach improves process stability.

In some embodiments, adjustments can be made by internal motors such as servos or stepper motors contained within the target assembly, which can be either submergible or contained inside a water-tight housing. These motors can apply torque directly to an adjustment screw, or there can be intermediate mechanics. The intermediate mechanics can be worm gears, bevel gears, or rack and pinions, for example, which change the direction of motion. Such mechanics can also serve as gear reductions in order to adjust the relative torque between the output torque of the motor and the desired torque to be applied to the adjustment screw.

In an alternative approach, piezo-electric motors can be utilized in the actuation mechanism. The piezo-electric motor provides a linear motion. This motion can be translated to rotary motion, to drive an adjustment screw, by applying tangential force to a gear that is affixed to the adjustment screw. Other linear motion options include electric solenoids, and pneumatic or hydraulic cylinders.

While power for internal motors can be provided by wires that are run through the water tube assembly, difficulties can arise in shielding these wires from the electrical power applied to the cathode, and because of the extra connection required when assembling the target. Alternately, power can be routed in by brush contacts, especially on a capped end of a single-ended cathode.

A method of driving internal motors is by providing battery packs within the target cavity. As battery packs hold a finite amount of energy, the number of adjustments during a production campaign can be limited. In most cases, battery life will be sufficient since the number of adjustments required will be few. In order to augment the system power, one or more optional power generator modules, such electrical generators, can be added to the magnetron assembly. Output power, from the generator modules, can be used to keep the batteries charged or used to directly drive the motors of the magnetron assembly. Mechanical energy, needed to drive the generator modules, can be harnessed from the flow of the cooling water, or by the rotational energy of the target cylinder relative to the magnetron assembly. For example, small turbine generators that run off the water flow can be implemented in the generator modules in one embodiment.

In general, pneumatic embodiments of the actuator require less power than motorized embodiments.

In another embodiment, an electronic internal control module can be located within the target assembly. Command and feedback communications between the operator and the internal control module can be done by a variety of methods that do not require significant alteration of the cathode.

One method for remote communicating with the internal control module is by a power-line overlay signal. In this case, the communications signal is transmitted through the same conductance path as the power applied to the target. However, communications frequencies must be chosen to be very different from any power frequency of the sputtering power supply. Additionally, it may be necessary to send redundant signals to compensate for electrical noise that is occasionally generated by the sputtering process. This method of communication has the advantages of being easily implemented in most rotary cathode designs with virtually no modifications to the cathode structure and requires no special feed-through.

Alternate methods of communicating with the control module include transmitting signals through a window in the cathode or target assembly. The most convenient place for such a window is as the center of the end cap of the single-ended type cathode. In this way, it is not necessary to adapt the end-block to comprise connectors, as with the '920 publication. It is not even necessary to provide a connector. Rather, in the present configuration of the windowed end cap, it is only necessary that optical fibers, on either side of the window, are in sufficient proximity and alignment to effectively communicate, and are sufficiently shielded from the plasma to prevent signal noise.

Exemplary types of signals that can be sent through this window include radio, Wi-Fi, Bluetooth, optical, magnetic induction, or the like. Digital optical communications have the advantage of being immune to interference from electromagnetic noise produced by the sputtering process, but the communication path needs reasonable shielding from light. Radio and Wi-Fi signals need shielding from electro-magnetic noise. Magnetic induction communication involve two inductive coils in close proximity, where a first coil is activated by an electric current and a second coil acts as a pick-up coil that generates a voltage signal in response to the magnetic field produced by the first coil. All of these methods can provide two-way communications. A variation of the magnetic induction method is to replace one of the coils with a Hall sensor, but this limits communications to one-way.

Another alternative for remote communication is by use of a pair of ultrasonic transceivers. Ultrasonic communication has the advantage in that there is more versatility in where the transceivers are mounted, since they do not require line-of-sight or any special window through which to transmit. Additionally, ultrasonic transceivers do not suffer from any electro-magnetic noise, optical noise, or optical impedance. The advantages of ultrasonic communication make it easier to retrofit cathodes produced by a variety of manufacturers.

A method of sensing the position of the magnet assembly, relative the target working surface, is also provided. In one approach, direct measurement is performed using an analog or digital linear motion indicator. If the motion is driven by servos or stepper motors, a feedback signal is available from these motors. An alternate method for sensing position is to measure gas pressure inside the pneumatic elements. Another method is to have a magnet and a Hall probe mounted in the apparatus such that they move relative to one another as adjustments are made. The Hall probe will have a different voltage output depending on its distance from the magnet.

The various techniques disclosed herein can be used to position the entire magnet assembly as a single unit, or to position multiple points along the length of the magnet assembly, independently, so as to make it possible to also adjust uniformity of the process.

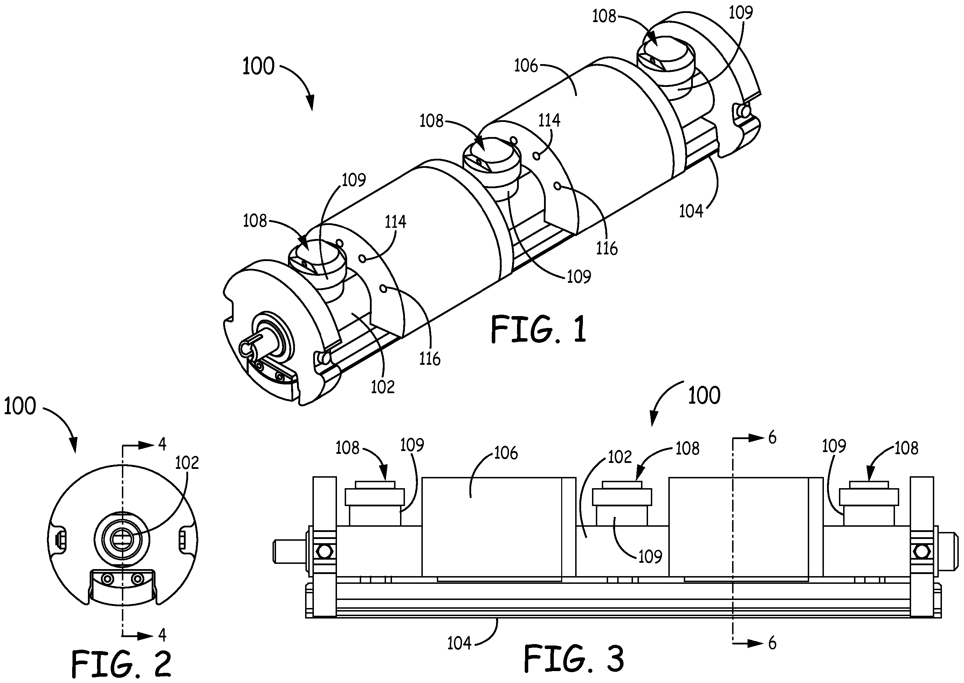

Figures 1-3 and 6 illustrate various views of a magnetron assembly 100 for a rotatable target cylinder according to one embodiment. In general, magnetron assembly 100 includes a rigid support structure 102 such as a coolant tube, a magnet bar structure 104 movably attached to support structure 102, and one or more actuation mechanisms 108 coupled to support structure 102. The actuation mechanisms 108 are configured to change a distance of magnet bar structure 104 from a surface of the rotatable target cylinder.

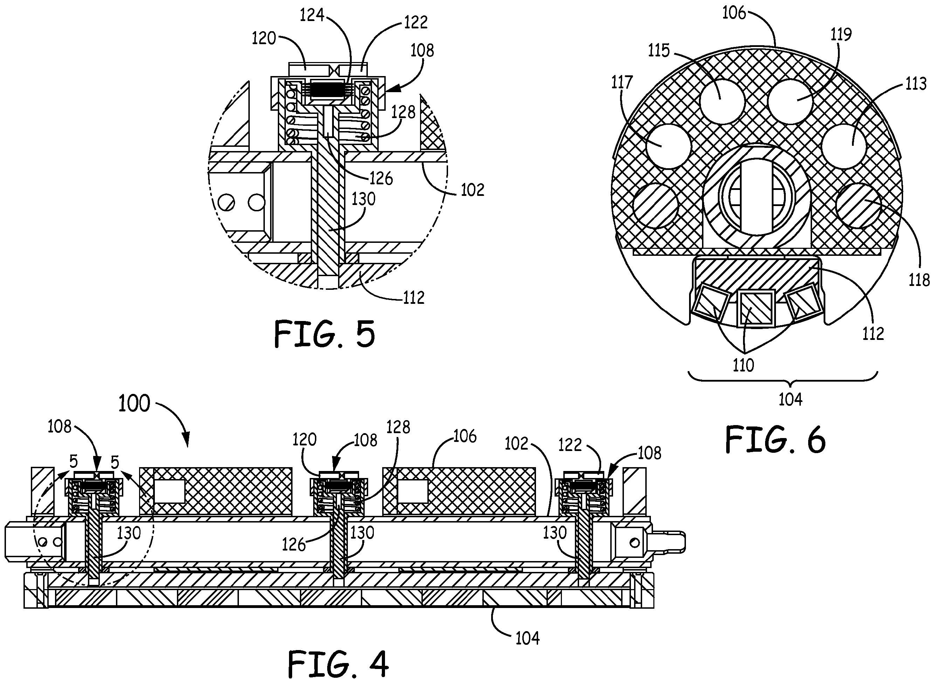

The actuation mechanisms 108 are covered by an actuator housing 109. A position indicating mechanism is located in actuator housing 109 and is operative to measure the position of magnet bar structure 104 relative to the surface of the rotatable target cylinder. The magnet bar structure 104 includes an array of substantially parallel rows of magnets 110 attached to a yoke 112, as shown in Figure 6. The yoke 112 is comprised of a magnetically conductive material such as steel, which helps to complete a magnetic circuit.

A control housing 106 partially surrounds support structure 102 and contains a communications device configured to receive command signals from outside of magnetron assembly 100 and transmit information signals to outside of magnetron assembly 100. The control housing 106 also encloses an electronic controller in operative communication with actuation mechanisms 108. The communications device can be a transceiver that is operatively coupled to the electronic controller. The transceiver can be a radio frequency (RF) transceiver, an optical transceiver, or an ultrasonic transceiver, for example. As shown in Figure 1, control housing 106 defines a position feedback connection port 114 and one or more actuation connection ports 116.

The position indicating mechanism can be implemented as a built-in position sensor in each actuation mechanism 108. The position sensor can measure the position of magnet bar structure 104 either by direct sensing or by an indirect metric. For example, the position indicating mechanism can be implemented with a Hall probe and a magnet in an analog sensor. Alternatively, the position indicating mechanism can be implemented with a digital indicator, such as a plunger style digital indicator, which transmits data directly to an operator without additional processing.

In addition, a power source can be provided to energize actuator mechanisms 108 and the electronic controller. The power source can be fully self-contained within the volume of the magnetron assembly. For example, a power supply such as a battery pack can be located in control housing 106.

The actuation mechanisms 108 can be implemented in various ways. For example, the actuation mechanisms 108 can include a spring-loaded pneumatic structure or a spring loaded hydraulic structure. Alternatively, the actuation mechanisms 108 can include a rotary cable or a push/pull cable.

In one embodiment, each actuation mechanism 108 can include a spring-loaded pneumatic bellows, bladders, or cylinders. In this approach, adjustment points are spring loaded with the pressure in the pneumatic element pushing in the opposite direction. Reserve energy for making adjustments can be stored in a compressed gas supply such as a CO₂ gas cartridge. Adjustments can be made by adjustment valves that either release compressed gas from the CO₂ gas cartridge into the pneumatic elements, or release gas from the pneumatic elements into cooling water inside the target.

Further details of one embodiment of actuation mechanisms 108 with built-in position sensing are depicted in Figures 4 and 5. In this embodiment, the actuation mechanisms 108 include a sensor port 120 for a Hall probe, a pneumatic actuation port 122 configured to receive a compressed gas, and a bellows 124 such as a welded bellows in communication with pneumatic actuation port 122. A control shaft 130 is coupled to bellows 124 and yolk 112 of magnet bar structure 104. A return spring 128 is coupled to control shaft 130, and a magnet 126 is located in control shaft 130 for Hall probe feedback. The Hall probe/magnet in this embodiment is an analog detector for position sensing. Figure 6 illustrates exemplary locations within control housing 106 for a control board 113 for the controller, one or more solenoid valves 115, transceivers 117, a CO₂ gas cartridge 118 in fluid communication with the solenoid valves, and a battery 119 to run the control board, which are used with the actuation mechanisms 108 of Figures 4 and 5.

As discussed previously, the actuation mechanisms can alternatively be implemented with a motorized structure, such as a servo, a stepper motor, or a piezo-electric motor. Any number of mechanical configurations can be used for the drive motion. One example is a screw jack, which may additionally incorporate right-angle gears or reduction gears. In these embodiments, position sensing of the magnet bar can be carried out through feedback from the motorized structures.

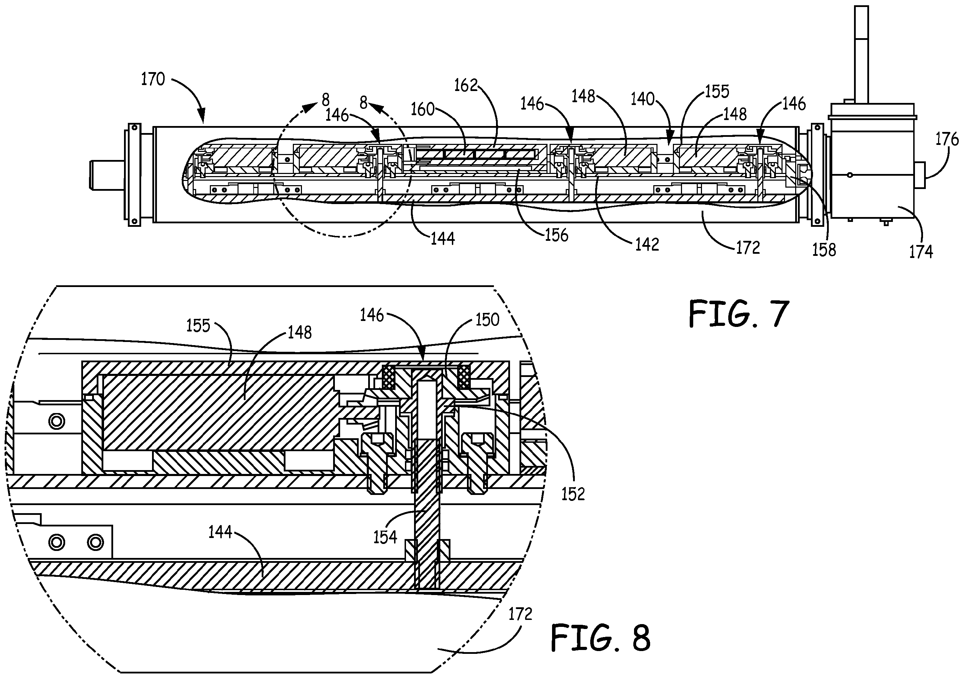

Figures 7 and 8 illustrate a magnetron assembly 140 implemented with a motorized structure in a rotatable target cathode 170 according to one embodiment. In general, magnetron assembly 140 is disposed inside of a target cylinder 172 and includes a rigid support structure 142, a magnet bar structure 144 movably attached to support structure 142, and a plurality of motorized actuation mechanisms 146 coupled to support structure 142. The motorized actuation mechanisms 146 include geared stepper motors 148, which can have a 100:1 gear reduction, for example. A set of bevel gears 150 is operatively coupled to stepper motors 148. The bevel gears 150 can have a 4:1 gear reduction, for example. A threaded housing 152 is mated with each of bevel gears 150. A threaded post 154 is coupled between magnet bar structure 144 and threaded housing 152. An actuator housing 155 encloses each of motorized actuation mechanisms 146.

The magnetron assembly 140 also includes an electronic controller 156 in operative communication with motorized actuation mechanisms 146. A communications device such as an ultrasonic transceiver/transducer 158 is operatively coupled to electronic controller 156. Power for stepper motors 148 and electronic controller 156 can be provided by a battery pack 160. A control housing 162 encloses electronic controller 156 and battery pack 160.

The target cylinder 172 is rotatably attached to an end block 174 as shown in Figure 7. An ultrasonic transceiver/transducer 176 is mounted on end block 174 and is in communication with ultrasonic transceiver/transducer 158.

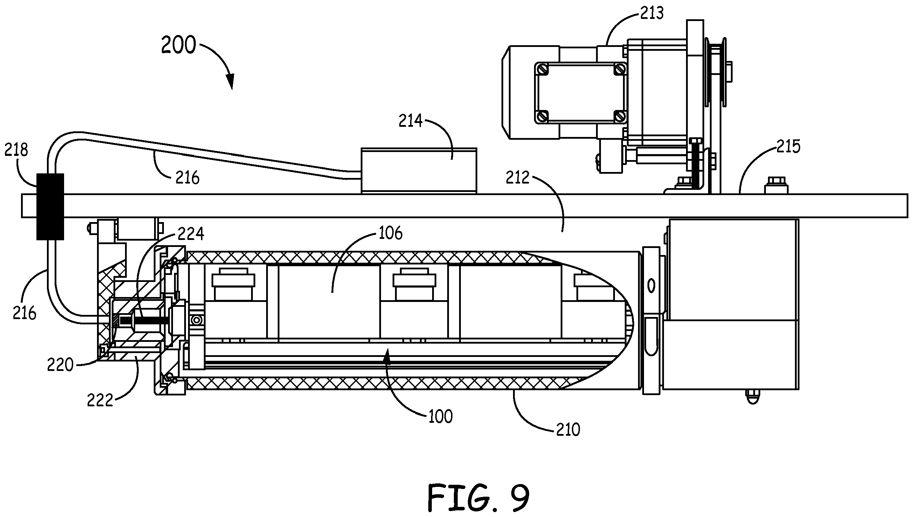

Figure 9 illustrates a sputtering apparatus 200 according to another embodiment that is configured for two-way optical communications. A rotatable cathode target cylinder 210 is disposed within a vacuum chamber 212 having an outer wall 215. The target cylinder 210 is operatively coupled to a motor 213 mounted on outer wall 215 outside of vacuum chamber 212. A magnetron assembly 100, such as described previously with respect to Figures 1-3, is located within target cylinder 210.

As depicted in Figure 9, an optical communications box 214 is located outside of vacuum chamber 212 on outer wall 215. A first fiber optic cable 216 in atmosphere is optically coupled to a first optical transceiver in optical communications box 214. The fiber optic cable 216 is also coupled to a vacuum coupler 218, which provides a feedthrough from atmosphere to vacuum for fiber optic cable 216. A second fiber optic cable 224 is coupled to a second optical transceiver inside control housing 106 through a cathode water cooling circuit of target cylinder 210. A fiber optic window 220 in an end cap 222 of target cylinder 210 allows an optical signal to be transmitted between fiber optic cable 216 and fiber optic cable 224.

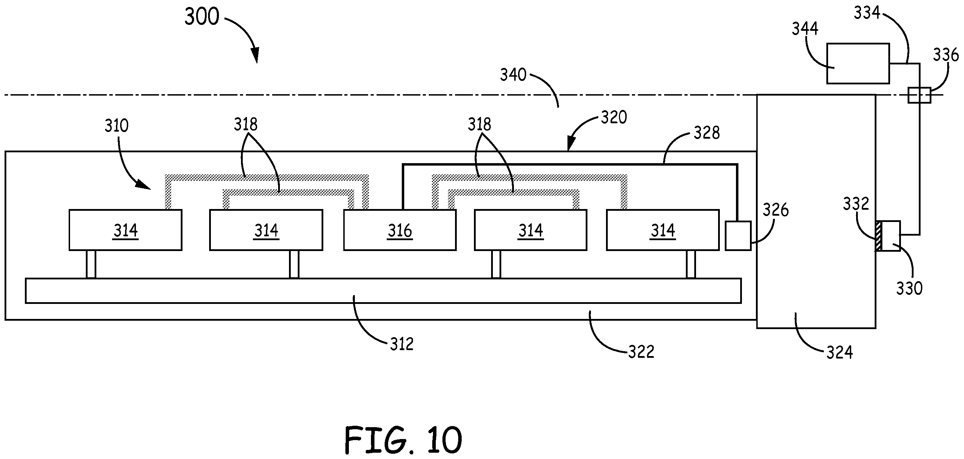

Figure 10 is a schematic illustration of a sputtering apparatus 300 according to another embodiment, which is configured for two-way ultrasonic communications between a magnetron assembly 310, located within a rotary cathode assembly 320 in a vacuum chamber 340, and an external controller 344 outside of vacuum chamber 340. The magnetron assembly 310 includes a magnet bar structure 312, and a plurality of motorized actuation mechanisms 314 mechanically coupled magnet bar structure 312. An internal electronic controller 316 is in operative communication with motorized actuation mechanisms 314, such as through motor control cables 318 that can include two sets of twisted pairs. A battery pack housed with electronic controller 316 provides power to motorized actuation mechanisms 314 and electronic controller 316.

The rotary cathode assembly 320 includes a target cylinder 322, which can be filled with water, rotatably coupled to an end block 324. A first ultrasonic transceiver 326 is mounted inside of target cylinder 322 and is in signal communication with electronic controller 316, such as through an ultrasonic communication wire 328 that can include one twisted pair. A second ultrasonic transceiver 330 is mounted on end block 324 over an insulator 332 and is in ultrasonic communication with ultrasonic transceiver 326. The external controller 344, which can be operated by a user, is in signal communication with ultrasonic transceiver 330, such as through an ultrasonic communication wire 334 that passes through a vacuum coupler 336, which provides a feedthrough from atmosphere to vacuum chamber 340.

In one implementation, electronic controller 316 is capable of controlling up to twelve (12) axes of motion for magnet bar structure 312, with only one motor of a motorized actuation mechanism 314 being controlled at any one time. The control theory for electronic controller 316 can be adapted to move each motor a small amount in a given sequence. Controlling only one motor at a time simplifies the control system and reduces the battery requirements as there is a lower instantaneous power draw. In addition, the control lines can be routed with a communications bus on the magnet bar side of an I-beam support. A water sealed electrical connection can be used between each controlled unit and the communications bus.

In another embodiment, a system for two-way transmission of information between a magnetron assembly contained within a cathode target assembly and outside of a vacuum chamber can also be provided. For example, two-way communications can be carried out by two RF transceivers strategically placed, with one transceiver inside the target assembly and one transceiver outside the target assembly but inside the vacuum chamber. The transceiver inside the target assembly is directly connected to the electronic controller. The transceiver in the vacuum chamber is connected to the outside via an electrical feed-through in the chamber wall. It is necessary to provide a window between transceiver antennas that is transparent to the communication signal. The window can be located as part of the end cap of the single-ended cathode.

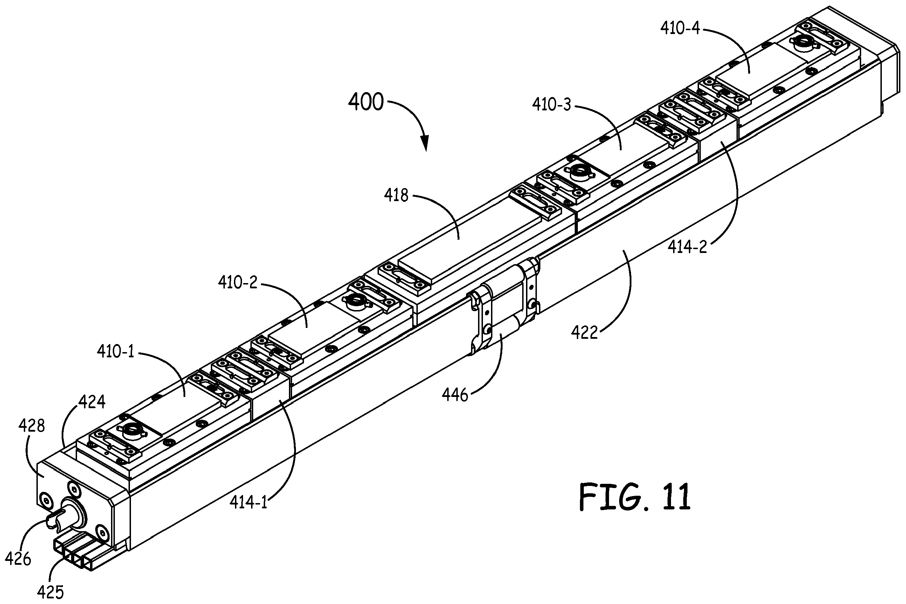

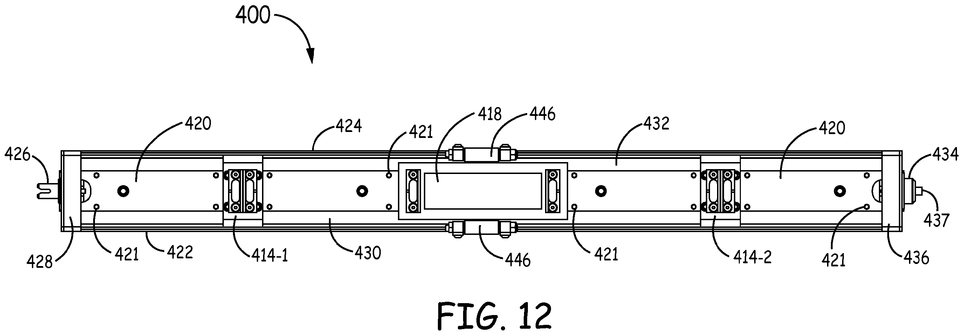

Figures 11 and 12 illustrate a magnetron assembly 400 for a rotary target cathode according to another embodiment. The magnetron assembly 400 generally includes a plurality of drive modules 410, and a plurality of power generation modules 414 located along the length of magnetron assembly 400. The magnetron assembly 410 also includes a controller and battery module 418 in operative communication with drive modules 410 and power generation modules 414. The drive modules 410, power generation modules 414, and controller and battery module 418, are each positioned between a pair of opposing side walls 422, 424 that extend along the length of magnetron assembly 400.

As shown in the exemplary embodiment of Figure 11, a first drive module 410-1 and a second drive module 410-2 are located on opposite sides of a first power generation module 414-1. A third drive module 410-3 and a fourth drive module 410-4 are located on opposite sides of a second power generation module 414-2, which can act as a redundant power generation source in case power generation module 410-1 fails. The controller and battery module 418 is located in a central portion of magnetron assembly 400 between drive module 410-2 and drive module 410-3.

Figure 12 is a top view of magnetron assembly 400, with the drive modules removed. An elongated support structure 420, such as an I-beam, extends along the bottom of magnetron assembly 400 between side walls 422 and 424. A plurality of apertures 421 in support structure 420 allows the drive modules to be coupled to support structure 420 with standard fasteners. The power generation modules 414-1, 414-2, and the controller and battery module 418, can be coupled to support structure 420 is a similar manner.

A magnet bar structure 425 with an array of magnets (Fig. 11) is movably positioned along the bottom of magnetron assembly 400 below support structure 420. The drive modules 410 each include a motorized actuation mechanism operatively coupled to magnet bar structure 425 to provide adjustments in the position of magnet bar structure 425. The controller and battery module 418 includes an electronic controller and at least one rechargeable battery.

The power generation modules 414 are in electrical communication with the rechargeable battery such that electrical energy output from power generation modules 414 can charge the battery when needed. Electrical power from the battery is configured to energize the motorized actuation mechanisms and the electronic controller. Alternatively, the power generation modules can be configured to directly drive the motorized actuation mechanisms.

As depicted in Figure 12, a first water inlet/outlet structure 426 at one end of magnetron assembly 400 extends through a first end structure 428 and is in fluid communication with a pair of cooling pipes 430, 432. A second water inlet/outlet structure 434 at an opposite end of magnetron assembly 400 extends through a second end structure 436 and is also in fluid communication with cooling pipes 430, 432. In one embodiment, a fiber optic holder 437 extends through water inlet/outlet structure 434. The fiber optic holder 437 is configured to support a fiber optic cable, which is coupled to an optical transceiver in communication with the electronic controller.

A set of target cylinder rollers 446 can be located on side walls 422 and 424. The rollers 446 provide movable surfaces that allow a target cylinder to more easily rotate around magnetron assembly 440.

In one embodiment, mechanical energy needed to drive power generation modules 414, can be harnessed from the flow of the cooling water through cooling pipe 430 or cooling pipe 432. For example, power generation modules 414 can include small turbine generators that are in fluid communication with water flowing through one or more of the cooling pipes. In an alternative embodiment, the mechanical energy needed to drive power generation modules 414 can be harnessed from the rotational energy of a target cylinder surrounding magnetron assembly 400.

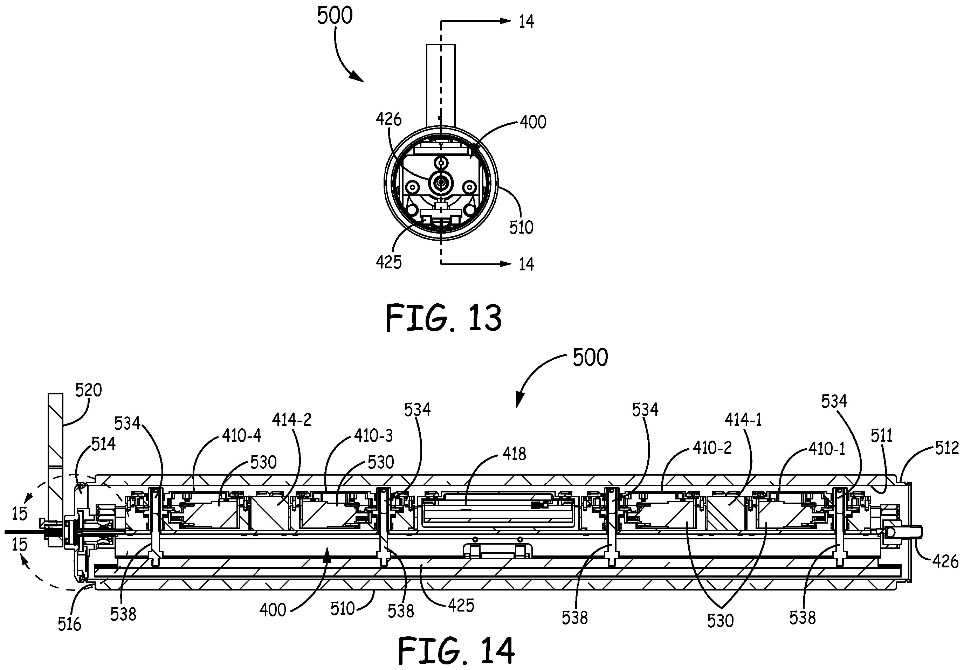

Figures 13 and 14 illustrate a rotary target cathode 500 that is implemented with magnetron assembly 400 according to one embodiment. The cathode 500 includes a rotatable target cylinder 510 having an inner surface 511 that defines an interior passageway. The magnetron assembly 400 is disposed in the interior passageway of target cylinder 510. The target cylinder 510 is configured at a proximal end 512 for mounting to an end block of a sputtering apparatus, such as end block 174 (Figure 7). A target end cap 514 is affixed to a distal end 516 of target cylinder 510.

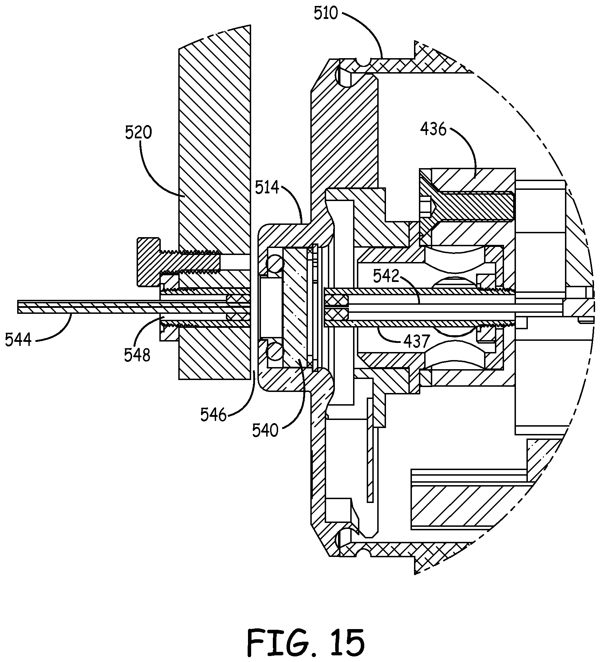

A fiber optic support 520 is configured to be mounted to a vacuum chamber wall of the sputtering apparatus, such as wall 215 (Fig. 9), with fiber optic support 520 being adjacent to but spaced apart from end cap 514. The end cap 514 and fiber optic support 520 are described in further detail with reference to Figure 15 hereafter.

Figure 14 shows further details of magnetron assembly 400. Each of drive modules 410 includes a motor 530 such as a stepper motor operatively coupled to an actuation mechanism 534. A set of actuation posts 538 is coupled between magnet bar structure 425 and each actuation mechanism 534. The motorized actuation mechanisms 534 provide for adjustments in the position of magnet bar structure 425 relative to inner surface 511 of target cylinder 510. For example, when target cylinder 510 erodes during operation of the sputtering apparatus, the motorized actuation mechanisms adjust the position of magnet bar structure 425 with respect to inner surface 511 in response to control signals from the electronic controller in controller and battery module 418.

As illustrated in Figure 15, end cap 514 houses a window 540 that allows an optical signal to be transmitted between a first fiber optic cable 542 and a second fiber optic cable 544. The fiber optic support 520 is positioned such that a small gap 546 exists between facing surfaces of fiber optic support 520 and end cap 514, where the optical signal is transmitted between fiber optic cables 542 and 544. The first fiber optic cable 542 extends into fiber optic holder 437, coupled to end cap 514, from magnetron assembly 400. The second fiber optic cable 544 extends into an opening 548 of fiber optic support 520.

In one embodiment, fiber optic cable 544 is in optical communication with an optical transceiver located outside of a vacuum chamber in which target cathode 500 is implemented. The fiber optic cable 542 is optically coupled to an optical transceiver in communication with the electronic controller in controller and battery module 418. The tips of fiber optic cables 542 and 544, on either side of window 540, are in sufficient alignment such that optical signals can be effectively transmitted between fiber optic cables 542 and 544.

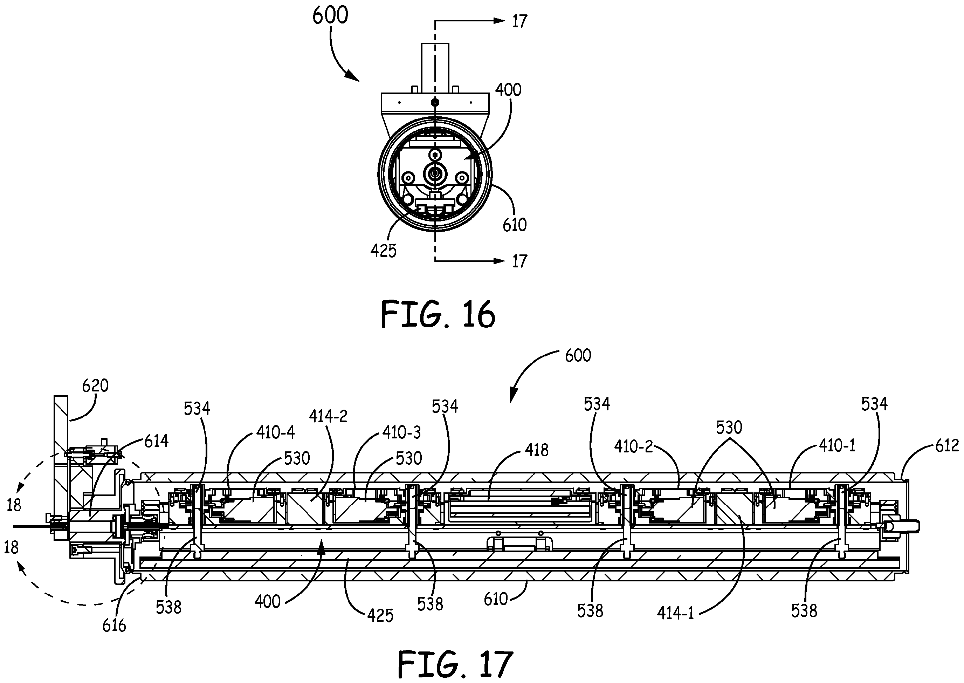

Figures 16 and 17 illustrate a rotary target cathode 600 that is implemented with magnetron assembly 400 according to another embodiment. The cathode 600 includes a rotatable target cylinder 610 that is configured at a proximal end 612 for mounting to an end block. A target end cap 614 is affixed to a distal end 616 of target cylinder 610.

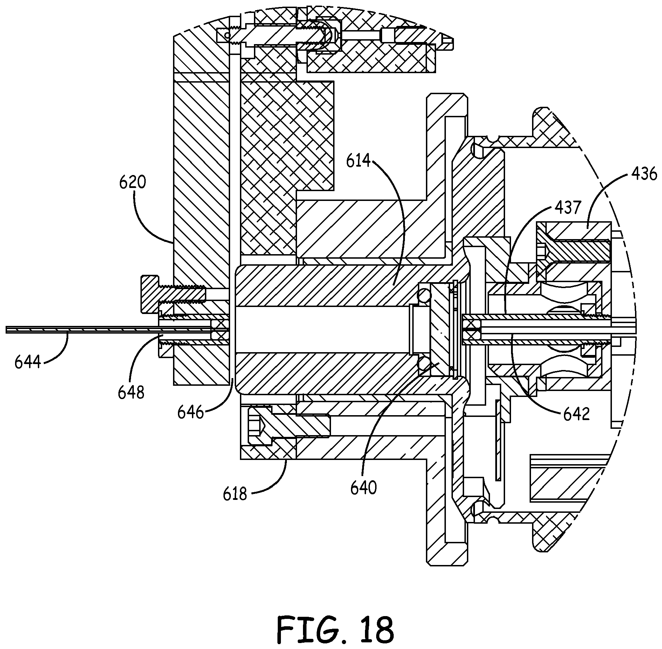

A target end support 618, configured to be mounted to a vacuum chamber wall of a sputtering apparatus, is coupled to end cap 614. A fiber optic support 620, configured to be mounted to the vacuum chamber wall, is positioned such that fiber optic support 620 is adjacent to but spaced apart from end cap 614. The end cap 614 and fiber optic support 620 are described in further detail with reference to Figure 18 hereafter.

Figure 17 shows further details of magnetron assembly 400, which include the same components as shown in Figure 14. As such, drive modules 410 each include a motor 530 coupled to an actuation mechanism 534. A set of actuation posts 538 is coupled between magnet bar structure 425 and each actuation mechanism 534. The motorized actuation mechanisms 534 provide for adjustments in the position of magnet bar structure 425 relative to the inner surface of target cylinder 610.

As illustrated in Figure 18, end cap 614 houses a window 640 that allows an optical signal to be transmitted between a first fiber optic cable 642 and a second fiber optic cable 644. The fiber optic support 620 is positioned such that a small gap 646 exists between facing surfaces of fiber optic support 620 and end cap 614, where the optical signal is transmitted between fiber optic cables 642 and 644. The first fiber optic cable 642 extends into fiber optic holder 437, coupled to end cap 614, from magnetron assembly 400. The second fiber optic cable 644 extends into an opening 648 of fiber optic support 620.

In one embodiment, fiber optic cable 644 is in optical communication with an optical transceiver located outside of a vacuum chamber in which target cathode 600 is implemented. The fiber optic cable 642 is optically coupled to an optical transceiver in communication with the electronic controller in controller and battery module 418. The tips of fiber optic cables 642 and 644, on either side of window 640, are in sufficient alignment such that optical signals can be effectively transmitted between fiber optic cables 642 and 644.

### EXAMPLE EMBODIMENTS

Example 1 includes a magnetron assembly for a rotary target cathode, the magnetron assembly comprising: an elongated support structure; a magnet bar structure movably positioned below the support structure; a plurality of drive modules coupled to the support structure, the drive modules each including a motorized actuation mechanism operatively coupled to the magnet bar structure; a controller and battery module coupled to the support structure and in operative communication with the drive modules, the controller and battery module including an electronic controller and at least one rechargeable battery, the battery configured to energize each motorized actuation mechanism and the electronic controller; and one or more power generation modules coupled to the support structure and in electrical communication with the battery such that electrical energy output from the power generation modules recharges the battery.
Example 2 includes the magnetron assembly of Example 1, wherein the one or more power generation modules are configured to directly drive the motorized actuation mechanism in each of the drive modules.
Example 3 includes the magnetron assembly of any of Examples 1-2, further comprising at least one cooling pipe that extends along the support structure.
Example 4 includes the magnetron assembly of Example 3, wherein the one or more power generation modules are in fluid communication with the cooling pipe.
Example 5 includes the magnetron assembly of Example 4, wherein mechanical energy for driving the one or more power generation modules is harnessed from water that flows through the cooling pipe.
Example 6 includes the magnetron assembly of Example 5, wherein the one or more power generation modules include a turbine generator in fluid communication with the water that flows through the cooling pipe.
Example 7 includes the magnetron assembly of any of Examples 1-6, wherein the magnet bar structure includes an array of magnets that extends along and under the support structure.
Example 8 includes the magnetron assembly of any of Examples 1-7, further comprising a fiber optic cable optically coupled to an optical transceiver in communication with the electronic controller.
Example 9 includes the magnetron assembly of Example 8, further comprising a fiber optic holder that extends from one end of the magnetron assembly and supports an end section of the fiber optic cable.
Example 10 includes a rotary target cathode assembly for a sputtering apparatus, the rotary target cathode assembly comprising: a rotatable target cylinder having an inner surface that defines an interior passageway, the target cylinder configured at a proximal end for mounting to an end block of the sputtering apparatus; a target end cap affixed to a distal end of the target cylinder; and a magnetron assembly disposed in the interior passageway of the target cylinder. The magnetron assembly comprises: an elongated support structure; a magnet bar structure movably positioned below the support structure; a plurality of drive modules coupled to the support structure, the drive modules each including a motorized actuation mechanism operatively coupled to the magnet bar structure; a controller and battery module coupled to the support structure and in operative communication with the drive modules, the controller and battery module including an electronic controller and at least one rechargeable battery, the battery configured to energize each motorized actuation mechanism and the electronic controller; and one or more power generation modules coupled to the support structure and in electrical communication with the battery such that electrical energy output from the power generation modules recharges the battery. As the target cylinder erodes during operation of the sputtering apparatus, the motorized actuation mechanisms adjust the position of the magnet bar structure with respect to the inner surface of the target cylinder in response to control signals from the electronic controller.
Example 11 includes the rotary target cathode assembly of Example 10, further comprising a fiber optic support configured to be mounted to a vacuum chamber wall of the sputtering apparatus such that the fiber optic support is adjacent to and spaced apart from the target end cap.
Example 12 includes the rotary target cathode assembly of any of Examples 10-11, and further comprising a first fiber optic cable optically coupled to a first optical transceiver in communication with the electronic controller, the first fiber optic cable extending into the target end cap from the magnetron assembly.
Example 13 includes the rotary target cathode assembly of Example 12, and further comprising a second fiber optic cable optically coupled to a second optical transceiver located outside of the vacuum chamber wall, the second fiber optic cable extending into an opening in the fiber optic support.
Example 14 includes the rotary target cathode assembly of Example 13, wherein the target end cap includes a window that allows an optical signal to be transmitted between the first fiber optic cable and the second fiber optic cable.
Example 15 includes the rotary target cathode assembly of any of Examples 10-14, wherein the one or more power generation modules is configured to directly drive the motorized actuation mechanism in each of the drive modules.
Example 16 includes the rotary target cathode assembly of any of Examples 10-15, and further comprising at least one cooling pipe that extends along the support structure of the magnetron assembly.
Example 17 includes the rotary target cathode assembly of Example 16, wherein the one or more power generation modules are in fluid communication with the cooling pipe.
Example 18 includes the rotary target cathode assembly of Example 17, wherein mechanical energy for driving the one or more power generation modules is harnessed from water that flows through the cooling pipe.
Example 19 includes the rotary target cathode assembly of Example 18, wherein the one or more power generation modules include a turbine generator in fluid communication with the water that flows through the cooling pipe.
Example 20 includes the rotary target cathode assembly of any of Examples 10-16, wherein mechanical energy for driving the one or more power generation modules is harnessed from rotational energy of the target cylinder.

While a number of embodiments have been described, it will be understood that the described embodiments are to be considered only as illustrative and not restrictive, and that various modifications to the described embodiments may be made without departing from the scope of the invention as defined by the appended claims.

## Claims

1. A magnetron assembly (100, 140, 310, 400) for a rotary target cathode, the magnetron assembly comprising:
an elongated support structure (102, 142, 420);
a magnet bar structure (104, 144, 312, 425) movably positioned below the support structure;
a plurality of drive modules (410) coupled to the support structure, the drive modules each including a motorized actuation mechanism (108, 146, 314, 534) operatively coupled to the magnet bar structure;
a controller and battery module (418) coupled to the support structure and in operative communication with the drive modules, the controller and battery module including an electronic controller (156, 316) and at least one rechargeable battery (119, 160), the battery configured to energize each motorized actuation mechanism and the electronic controller; and
**characterised by** comprising one or more power generation modules (414) coupled to the support structure and in electrical communication with the battery such that electrical energy output from the one or more power generation modules recharges the battery.

2. The magnetron assembly of claim 1, wherein the one or more power generation modules is configured to recharge the battery or directly drive the motorized actuation mechanism in each of the drive modules.

3. The magnetron assembly of claim 1, further comprising at least one cooling pipe (430, 432) that extends along the support structure.

4. The magnetron assembly of claim 3, wherein the one or more power generation modules are in fluid communication with the cooling pipe.

5. The magnetron assembly of claim 4, wherein mechanical energy for driving the one or more power generation modules is harnessed from water that flows, in use, through the cooling pipe.

6. The magnetron assembly of claim 5, wherein the one or more power generation modules include a turbine generator in fluid communication with the water that flows, in use, through the cooling pipe.

7. The magnetron assembly of claim I, wherein the magnet bar structure includes an array of magnets (110) that extends along and under the support structure.

8. The magnetron assembly of claim I, further comprising a fiber optic cable (216, 224) optically coupled to an optical transceiver in communication with the electronic controller.

9. The magnetron assembly of claim 8, further comprising a fiber optic holder (437) that extends from one end of the magnetron assembly and supports an end section of the fiber optic cable.

10. A rotary target cathode assembly (170, 320, 500, 600) for a sputtering apparatus (200, 300), the rotary target cathode assembly including a magnetron assembly according to claim 1 and comprising:
a rotatable target cylinder (172, 210, 322, 510, 610) having an inner surface (511) that defines an interior passageway, the target cylinder configured at a proximal end (512, 612) for mounting to an end block (174, 324) of the sputtering apparatus; and
a target end cap (222, 514, 614) affixed to a distal end (516, 616) of the target cylinder;
wherein the magnetron assembly is disposed in the interior passageway of the target cylinder; and
wherein as the target cylinder erodes during operation of the sputtering apparatus, the motorized actuation mechanisms are configured to adjust the position of the magnet bar structure with respect to the inner surface of the target cylinder in response to control signals from the electronic controller.

11. The rotary target cathode assembly of claim 10, further comprising a fiber optic support (520) configured to be mounted to a vacuum chamber wall (215) of the sputtering apparatus such that the fiber optic support is adjacent to and spaced apart from the target end cap.

12. The rotary target cathode assembly of claim 11, further comprising a first fiber optic cable (224) optically coupled to a first optical transceiver in communication with the electronic controller, the first fiber optic cable extending into the target end cap from the magnetron assembly.

13. The rotary target cathode assembly of claim 12, further comprising a second fiber optic cable (226) optically coupled to a second optical transceiver located outside of the vacuum chamber wall, the second fiber optic cable extending into an opening in the fiber optic support.

14. The rotary target cathode assembly of claim 13, wherein the target end cap includes a window (220, 540, 640) that allows an optical signal to be transmitted between the first fiber optic cable and the second fiber optic cable.

15. The rotary target cathode assembly of claim 10, wherein the one or more power generation modules is configured to recharge the battery or directly drive the motorized actuation mechanism in each of the drive modules.

16. The rotary target cathode assembly of claim 10, further comprising at least one cooling pipe (430, 432) that extends along the support structure of the magnetron assembly.

17. The rotary target cathode assembly of claim 16, wherein the one or more power generation modules are in fluid communication with the cooling pipe.

18. The rotary target cathode assembly of claim 17, wherein mechanical energy for driving the one or more power generation modules is harnessed from water that flows, in use, through the cooling pipe.

19. The rotary target cathode assembly of claim 18, wherein the one or more power generation modules include a turbine generator in fluid communication with the water that flows, in use, through the cooling pipe.

20. The rotary target cathode assembly of claim 10, wherein mechanical energy for driving the one or more power generation modules is harnessed in use, from rotational energy of the target cylinder.

## Patentansprüche

1. Magnetron-Anordnung (100, 140, 310, 400) für eine drehbare Targetkathode, wobei die Magnetron-Anordnung umfasst:
eine längliche Tragstruktur (102, 142, 420);
eine Magnetstangenstruktur (104, 144, 312, 425), die beweglich unter der Tragstruktur angeordnet ist;
mehrere Antriebsmodule (410), die mit der Tragstruktur verbunden sind, wobei die Antriebsmodule jeweils einen motorisierten Betätigungsmechanismus (108, 146, 314, 534) enthalten, der mit der Magnetstangenstruktur wirkverbunden ist;
ein Steuerungs- und Batteriemodul (418), das mit der Tragstruktur verbunden ist und in Wirkverbindung mit den Antriebsmodulen steht, wobei das Steuerungs- und Batteriemodul eine elektronische Steuervorrichtung (156, 316) und mindestens eine wiederaufladbare Batterie (119, 160) aufweist, wobei die Batterie ausgebildet ist, um jedem motorisierten Betätigungsmechanismus und der elektronischen Steuervorrichtung Energie zuzuführen; und
**dadurch gekennzeichnet, dass** es ein oder mehrere Stromerzeugungsmodule (414) umfasst, die mit der Tragstruktur verbunden sind und mit der Batterie in elektrischer Verbindung stehen, sodass die elektrische Energie, die von dem einen oder den mehreren Stromerzeugungsmodulen abgegeben wird, die Batterie wieder auflädt.

2. Magnetron-Anordnung nach Anspruch 1, wobei das eine oder die mehreren Stromerzeugungsmodule ausgebildet sind, um die Batterie aufzuladen oder den motorisierten Betätigungsmechanismus direkt in jedem der Antriebsmodule anzutreiben.

3. Magnetron-Anordnung nach Anspruch 1, ferner umfassend mindestens ein Kühlrohr (430, 432), das sich entlang der Tragstruktur erstreckt.

4. Magnetron-Anordnung nach Anspruch 3, wobei das eine oder die mehreren Stromerzeugungsmodule in Fluidverbindung mit dem Kühlrohr stehen.

5. Magnetron-Anordnung nach Anspruch 4, wobei mechanische Energie für das Antreiben des einen oder der mehreren Stromerzeugungsmodule von Wasser genutzt wird, das bei Gebrauch durch das Kühlrohr fließt.

6. Magnetron-Anordnung nach Anspruch 5, wobei das eine oder die mehreren Stromerzeugungsmodule einen Turbinengenerator aufweisen, welcher in Fluidverbindung mit dem Wasser steht, das bei Gebrauch durch das Kühlrohr fließt.

7. Magnetron-Anordnung nach Anspruch 1, wobei die Magnetschienenstruktur ein Magnetenarray (110) einschließt, das sich entlang und unter der Tragstruktur erstreckt.

8. Magnetron-Anordnung nach Anspruch 1, ferner umfassend ein Glasfaserkabel (216, 224), das an einen optischen Transceiver optisch verbunden ist, welcher in Verbindung mit der elektronischen Steuervorrichtung ist.

9. Magnetron-Anordnung nach Anspruch 8, ferner umfassend einen faseroptischen Halter (437), der sich von einem Ende der Magnetron-Anordnung erstreckt und einen Endabschnitt des faseroptischen Kabels trägt.

10. Drehbare Targetkathodenanordnung (170, 320, 500, 600) für eine Zerstäubungsvorrichtung (200, 300), wobei die drehbare Targetkathodenanordnung eine Magnetron-Anordnung nach Anspruch 1 einschließt und Folgendes umfasst:
einen drehbaren Target-Zylinder (172, 210, 322, 510, 610) mit einer Innenfläche (511), die einen inneren Durchgang definiert, wobei der Target-Zylinder an einem proximalen Ende (512, 612) ausgebildet ist, um an einem Endblock (174, 324) der Zerstäubungsvorrichtung angebracht zu werden; und
eine Target-Endkappe (222, 514, 614), die an einem distalen Ende (516, 616) des Target-Zylinders befestigt ist;
wobei die Magnetron-Anordnung in dem inneren Durchgang des Target-Zylinders angeordnet ist; und
wobei, wenn der Target-Zylinder während des Betriebs der Zerstäubungsvorrichtung erodiert, die motorisierten Betätigungsmechanismen derart ausgebildet sind, dass sie die Position der Magnetstangenstruktur in Bezug auf die Innenfläche des Target-Zylinders als Reaktion auf Steuersignale der elektronischen Steuervorrichtung einstellen.

11. Drehbare Targetkathodenanordnung nach Anspruch 10, ferner umfassend einen faseroptischen Träger, (520) welcher ausgebildet ist, um an eine Vakuumkammerwand (215) der Sputtervorrichtung angebracht zu werden, sodass der faseroptische Träger zu der Target-Endkappe benachbart und von ihr beabstandet ist.

12. Drehbare Targetkathodenanordnung nach Anspruch 11, ferner umfassend ein erstes Glasfaserkabel (224), das optisch an einen ersten optischen Transceiver verbunden ist, welcher mit der elektronischen Steuervorrichtung in Kommunikation steht, wobei das erste Glasfaserkabel sich von der Magnetron-Anordnung in die Target-Endkappe erstreckt.

13. Drehbare Targetkathodenanordnung nach Anspruch 12, ferner umfassend einem zweiten Glasfaserkabel (226), das optisch mit einem zweiten optischen Transceiver verbunden ist, der sich außerhalb der Vakuumkammerwand befindet, wobei sich das zweite Glasfaserkabel in eine Öffnung in dem Glasfaserträger erstreckt.

14. Drehbare Targetkathodenanordnung nach Anspruch 13, wobei die Target-Endkappe ein Fenster (220, 540, 640) aufweist, das die Übertragung eines optischen Signals zwischen dem ersten Glasfaserkabel und dem zweiten Glasfaserkabel ermöglicht.

15. Drehbare Targetkathodenanordnung nach Anspruch 10, wobei das eine oder die mehreren Stromerzeugungsmodule ausgebildet sind, um die Batterie aufzuladen oder den motorisierten Betätigungsmechanismus direkt in jedem der Antriebsmodule anzutreiben.

16. Drehbare Targetkathodenanordnung nach Anspruch 10, ferner umfassend mindestens ein Kühlrohr (430, 432), das sich entlang der Tragstruktur der Magnetron-Anordnung erstreckt.

17. Drehbare Targetkathodenanordnung nach Anspruch 16, wobei das eine oder die mehreren Stromerzeugungsmodule in Fluidverbindung mit dem Kühlrohr stehen.

18. Drehbare Targetkathodenanordnung nach Anspruch 17, wobei mechanische Energie für das Antreiben des einen oder der mehreren Stromerzeugungsmodule von Wasser genutzt wird, das bei Gebrauch durch das Kühlrohr fließt.

19. Drehbare Targetkathodenanordnung nach Anspruch 18, wobei das eine oder die mehreren Stromerzeugungsmodule einen Turbinengenerator aufweisen, welcher in Fluidverbindung mit dem Wasser steht, das bei Gebrauch durch das Kühlrohr fließt.

20. Drehbare Targetkathodenanordnung nach Anspruch 10, wobei bei Gebrauch mechanische Energie zum Antreiben der eines oder mehrere Stromerzeugungsmodule von der Rotationsenergie des Target-Zylinders genutzt wird.

## Revendications

1. Ensemble magnétron (100, 140, 310, 400) pour une cathode cible rotative, l'ensemble magnétron comprenant :
une structure de support allongée (102, 142, 420) ;
une structure de barre magnétique (104, 144, 312, 425) positionnée de manière mobile sous la structure de support ;
une pluralité de modules d'entraînement (410) couplés à la structure de support, les modules d'entraînement comprenant chacun un mécanisme d'actionnement motorisé (108, 146, 314, 534) couplé fonctionnellement à la structure de barre magnétique ;
un dispositif de commande et un module de batterie (418) couplés à la structure de support et en communication fonctionnelle avec les modules d'entraînement, le dispositif de commande et le module de batterie comprenant un dispositif de commande électronique (156, 316) et au moins une batterie rechargeable (119, 160), la batterie étant configurée pour alimenter chaque mécanisme d'actionnement motorisé et le dispositif de commande électronique ; et
**caractérisé en ce qu'**il comprend un ou plusieurs modules de génération d'énergie (414) couplés à la structure de support et en communication électrique avec la batterie de telle sorte que l'énergie électrique fournie par le ou les modules de génération d'énergie recharge la batterie.

2. Ensemble magnétron selon la revendication 1, dans lequel le ou les modules de génération d'énergie sont configurés pour recharger la batterie ou entraîner directement le mécanisme d'actionnement motorisé dans chacun des modules d'entraînement.

3. Ensemble magnétron selon la revendication 1, comprenant en outre au moins un tuyau de refroidissement (430, 432) qui s'étend le long de la structure de support.

4. Ensemble magnétron selon la revendication 3, dans lequel le ou les modules de génération d'énergie sont en communication fluidique avec le tuyau de refroidissement.

5. Ensemble magnétron selon la revendication 4, dans lequel l'énergie mécanique destinée à entraîner le ou les modules de génération d'énergie provient de l'eau qui s'écoule, en fonctionnement, à travers le tuyau de refroidissement.

6. Ensemble magnétron selon la revendication 5, dans lequel le ou les modules de génération d'énergie comprennent un turbogénérateur en communication fluidique avec l'eau qui s'écoule, en fonctionnement, à travers le tuyau de refroidissement.

7. Ensemble magnétron selon la revendication 1, dans lequel la structure de barre magnétique comprend un réseau d'aimants (110) qui s'étend le long de la structure de support et en dessous.

8. Ensemble magnétron selon la revendication 1, comprenant en outre un câble à fibre optique (216, 224) couplé optiquement à un émetteur-récepteur optique en communication avec le dispositif de commande électronique.

9. Ensemble magnétron selon la revendication 8, comprenant en outre un support à fibre optique (437) qui s'étend depuis une extrémité de l'ensemble magnétron et supporte une section d'extrémité du câble à fibre optique.

10. Ensemble cathode cible rotative (170, 320, 500, 600) pour un appareil de pulvérisation (200, 300), l'ensemble cathode cible rotative comprenant un ensemble magnétron selon la revendication 1, et comprenant :
un cylindre cible rotatif (172, 210, 322, 510, 610) ayant une surface intérieure (511) qui définit un passage intérieur, le cylindre cible étant configuré à une extrémité proximale (512, 612) pour être monté sur un bloc d'extrémité (174, 324) de l'appareil de pulvérisation ; et
un capuchon d'extrémité cible (222, 514, 614) fixé à une extrémité distale (516, 616) du cylindre cible ;
l'ensemble magnétron étant disposé dans le passage intérieur du cylindre cible ; et
les mécanismes d'actionnement motorisés étant configurés pour ajuster la position de la structure de barre magnétique par rapport à la surface intérieure du cylindre cible en réponse aux signaux de commande du dispositif de commande électronique lorsque le cylindre cible s'érode pendant le fonctionnement de l'appareil de pulvérisation.

11. Ensemble cathode cible rotative selon la revendication 10, comprenant en outre un support de fibre optique (520) configuré pour être monté sur une paroi de chambre à vide (215) de l'appareil de pulvérisation de telle sorte que le support de fibre optique soit adjacent au capuchon d'extrémité cible et espacé de celui-ci.

12. Ensemble cathode cible rotative selon la revendication 11, comprenant en outre un premier câble à fibre optique (224) couplé optiquement à un premier émetteur-récepteur optique en communication avec le dispositif de commande électronique, le premier câble à fibre optique s'étendant dans le capuchon d'extrémité cible depuis l'ensemble magnétron.

13. Ensemble cathode cible rotative selon la revendication 12, comprenant en outre un second câble à fibre optique (226) couplé optiquement à un second émetteur-récepteur optique situé à l'extérieur de la paroi de la chambre à vide, le second câble à fibre optique s'étendant dans une ouverture dans le support de fibre optique.

14. Ensemble cathode cible rotative selon la revendication 13, dans lequel le capuchon d'extrémité cible comprend une fenêtre (220, 540, 640) qui permet la transmission d'un signal optique entre le premier câble à fibre optique et le second câble à fibre optique.

15. Ensemble cathode cible rotative selon la revendication 10, dans lequel le ou les modules de génération d'énergie sont configurés pour recharger la batterie ou entraîner directement le mécanisme d'actionnement motorisé dans chacun des modules d'entraînement.

16. Ensemble cathode cible rotative selon la revendication 10, comprenant en outre au moins un tuyau de refroidissement (430, 432) qui s'étend le long de la structure de support de l'ensemble magnétron.

17. Ensemble cathode cible rotative selon la revendication 16, dans lequel le ou les modules de génération d'énergie sont en communication fluidique avec le tuyau de refroidissement.

18. Ensemble cathode cible rotative selon la revendication 17, dans lequel l'énergie mécanique destinée à entraîner le ou les modules de génération d'énergie provient de l'eau qui s'écoule, en fonctionnement, à travers le tuyau de refroidissement.

19. Ensemble cathode cible rotative selon la revendication 18, dans lequel le ou les modules de génération d'énergie comprennent un turbogénérateur en communication fluidique avec l'eau qui s'écoule, en fonctionnement, à travers le tuyau de refroidissement.

20. Ensemble cathode cible rotative selon la revendication 10, dans lequel l'énergie mécanique destinée à entraîner le ou les modules de génération d'énergie provient, en fonctionnement, de l'énergie de rotation du cylindre cible.
